(19) **Europäisches Patentamt**

**European Patent Office**

**Office européen des brevets**

(11) **EP 0 767 569 B1**

(12) **FASCICULE DE BREVET EUROPEEN**

(45) Date de publication et mention
de la délivrance du brevet:
**04.08.2004 Bulletin 2004/32**

(51) Int Cl.⁷: **H04M 9/08**, H04B 3/23,
H04R 29/00

(21) Numéro de dépôt: **96401930.1**

(22) Date de dépôt: **10.09.1996**

(54) **Procédé et dispositif d'identification adaptative et annuleur d'écho adaptatif s'y rapportant**

Verfahren und Vorrichtung zur adaptiven Identifikation und entsprechender adaptiver
Echokompensator

Method and device for adaptive identification and related adaptive echo canceller

(84) Etats contractants désignés:
**DE GB IT**

(30) Priorité: **13.09.1995 FR 9510714**
**26.04.1996 FR 9605312**

(43) Date de publication de la demande:
**09.04.1997 Bulletin 1997/15**

(60) Demande divisionnaire:
**03020042.2 / 1 401 183**

(73) Titulaire: **FRANCE TELECOM**
**75015 Paris (FR)**

(72) Inventeurs:
 • **Scalart, Pascal**
  **22300 Ploubezre (FR)**
 • **Duhamel, Pierre**
  **92130 Issy les Moulineaux (FR)**

 • **Benamar, Abdelkrim**
  **77500 Chelles (FR)**

(74) Mandataire: **Loisel, Bertrand et al**
 **Cabinet Plasseraud**
 **65/67 rue de la Victoire**
 **75440 Paris Cedex 09 (FR)**

(56) Documents cités:
 **EP-A- 0 176 312      EP-A- 0 661 832**
 **GB-A- 2 208 983      US-A- 4 513 177**
 **US-A- 4 901 346**

 • **PATENT ABSTRACTS OF JAPAN vol. 95, no. 5 &
  JP-A-07 131389 (FUJITSU LTD), 19 Mai 1995,**
 • **PATENT ABSTRACTS OF JAPAN vol. 17, no. 69
  (E-1318) & JP-A-04 271622 (NEC CORP), 28
  Septembre 1992,**

**Description**

La présente invention concerne un procédé et un dispositif d'identification adaptative de système et, un annuleur d'écho adaptatif s'y rapportant.

L'essor actuel des télécommunications dans le domaine du grand public, et plus particulièrement des radiocommunications avec les mobiles, amène les concepteurs de ces systèmes à mettre en oeuvre des solutions techniques optimales en termes de confort d'utilisation.

Dans ce sens, les équipes industrielles de Recherche et de Développement sont fréquemment confrontées à des problèmes d'identification adaptative de systèmes. Parmi ces problèmes, on peut citer, dans le cadre des radiocommunications avec les mobiles, la problématique liée à l'égalisation des canaux de propagation et à l'annulation d'écho acoustique pour la radiotéléphonie mains-libres.

Ces problèmes d'identification de systèmes sont souvent résolus par l'utilisation de techniques de traitement du signal intégrant des procédés d'identification adaptative. Mais jusqu'à présent, aucun de ces dispositifs ne permet de s'ajuster automatiquement aux conditions de bruit environnant.

L'utilisation de telles techniques adaptatives d'identification de systèmes présente un inconvénient majeur qui réside dans la forte corrélation entre les performances atteintes et le choix des paramètres de contrôle leur étant associés. Ce choix est d'autant plus critique lorsque l'environnement d'utilisation de ces dispositifs évolue au cours du temps, comme cela peut être le cas, par exemple, pour l'annulation d'écho acoustique dans le contexte des radiocommunications avec les mobiles.

Ces dispositifs mettent en oeuvre des algorithmes d'identification qui sont caractérisés dans leur forme temporelle par les équations générales suivantes (voir S. Haykin, "Adaptive Filter Theory", Englewood Cliffs, N.J. Prentice-Hall, 1991) :

$$e_t = y_t - < H_{L,t-1}, X_{L,t} > \qquad (1)$$

$$H_{L,t} = H_{L,t-1} + \mu_t \cdot f(X_{L,t} ; e_t ; \lambda_t) \qquad (2)$$

où $<.,.>$ représente le produit scalaire entre deux vecteurs, $H_{L,t}$ est un vecteur représentant la réponse impulsionnelle du filtre d'identification de taille L à l'instant t, $\mu_t$ est un pas d'adaptation normalisé, $X_{L,t} = (x_t, x_{t-1},...,x_{t-L+1})$ est le vecteur constitué des L derniers échantillons du signal d'entrée $x_t$, $y_t$ est l'échantillon courant du signal d'observation, et est l'erreur de filtrage a priori, $\lambda_t$ est un facteur d'oubli, et f(.) est la fonction permettant de distinguer ces différents algorithmes. Notons que le facteur d'oubli permet d'estimer des coefficients de corrélation lissés dans le temps, ces coefficients étant inhérents aux algorithmes d'identification. L'algorithme NLMS (Normalized Least Mean Squares, voir l'ouvrage précité de S. Haykin), par exemple, est caractérisé par les équations suivantes :

$$e_t = y_t - < H_{L,t-1}, X_{L,t} > \qquad (1)$$

$$H_{L,t} = H_{L,t-1} + \mu_t \cdot \frac{e_t \cdot X_{L,t}}{\|X_{L,t}\|^2} \qquad (2bis)$$

où $\|.\|^2$ représente le carré de la norme d'un vecteur.

Cette formulation ((1) et (2)) fait référence à un algorithme temporel, mais on note que la méthode présentée ici est aussi valable pour les algorithmes fréquentiels.

En outre, certains algorithmes utilisent un pas d'adaptation et/ou un facteur d'oubli. Ainsi, les algorithmes des Moindres Carrés Récursifs Rapides (MCRR) (voir l'ouvrage précité de S. Haykin) utilisent uniquement un facteur d'oubli, tandis que les algorithmes de type gradient (voir l'ouvrage précité de S. Haykin) et de projection (voir l'article de K. Ozeki et T. Umeda, "An Adaptive Algorithm Using an Orthogonal Projection to an Affine Subspace and Its Properties", Electronics and Communications in Japan, vol. 67-A, n°5, pp.19-27, 1984) utilisent un pas d'adaptation et parfois un facteur d'oubli.

Comme évoqué précédemment, les performances de ces algorithmes (vitesse de convergence, capacité de poursuite des non-stationnarités, désajustement après convergence) sont intimement liées au choix des grandeurs $\lambda_t$ et $\mu_t$. Celles-ci sont ajustées, en général, en fonction de la nature des signaux traités et du niveau du bruit d'observation caractéristique de l'application souhaitée. Ainsi, dans le cas de signaux très bruités, il est conseillé de prendre un pas d'adaptation très proche de 0 et un facteur d'oubli très proche de 1 afin d'accroître la robustesse au bruit de ces algorithmes. Par contre, dans le cas de signaux faiblement bruités, un pas d'adaptation proche de 1 permet d'obtenir un plus grande rapidité de convergence de l'algorithme d'identification vers la solution optimale.

Plus généralement, dans les applications où le niveau de bruit varie au cours du temps (cas de figure couramment rencontré en pratique), le réglage de ces paramètres devient délicat et il est souvent réalisé en considérant les conditions les plus adverses. Ainsi, dans le cadre de l'annulation d'écho acoustique pour les radiotéléphones mains-libres, ces grandeurs sont ajustées de façon à obtenir un comportement satisfaisant dans des conditions difficiles (vitesse importante, vitres ouvertes,...). Il est, cependant, important de noter que ces réglages limitent les performances des algorithmes en question lorsque l'on se place dans des conditions moins adverses (véhicule à l'arrêt par exemple pour l'annulation d'écho acoustique).

Ces difficultés de réglage des paramètres de contrôle des algorithmes d'identification rendent cette procédure très coûteuse en temps de développement. Pour faire face à ce coût important, la recherche de formulations du pas d'adaptation et du facteur d'oubli prenant en compte les variations des caractéristiques du bruit d'observation a été entamée. Les informations présentes dans la littérature concernant des paramètres de contrôle variables permettent de distinguer deux types de solutions :

- la suite des pas d'adaptation ($\mu_t$) est définie de façon récurrente dans le temps, c'est-à-dire que $\mu_t$ est calculé en fonction de $\mu_{t-l},...,\mu_{t-N}$ pour une récurrence d'ordre N. Les valeurs d'initialisation sont en général liées à la puissance du signal d'observation, et elles ne tiennent pas compte explicitement des conditions de bruit. Un exemple de ce type est donné dans l'article de D.T.M. Slock, "On the Convergence Behavior of the LMS and the Normalized LMS Algorithms", IEEE Trans. on Signal Processing, vol. 41, N°9, pp.2811-2825, Septembre 1993.
- le pas d'adaptation est variable et dépend en général de la puissance à court terme de l'erreur résiduelle. Cette erreur introduit la notion de bruit ambiant dans la mesure où celui-ci est donné par la somme de l'erreur d'identification proprement dite et du bruit d'observation. Néanmoins, ce pas d'adaptation ne permet pas de distinguer l'importance relative du bruit d'observation et celle de l'erreur d'identification. Un exemple de ce type est donné dans l'article de H. Perez Meana et al., "A Time Varying Step Size Normalized LMS Echo Canceller Algorithm", Proc. of EUSIPCO-94, pp. II-249 - II-252, Edimburg, Ecosse, Septembre 1994.

Ainsi, aucune solution satisfaisante au problème ci-dessus exposé n'a pu être identifiée dans la littérature.

Un but de la présente invention est de proposer une telle solution.

L'invention propose ainsi un procédé d'identification adaptative pour estimer la réponse d'un système à un signal d'entrée, dans lequel on reçoit d'une part le signal d'entrée et d'autre part un signal d'observation dont une composante est ladite réponse au signal d'entrée, on détermine un signal d'erreur en soustrayant du signal d'observation le signal d'entrée filtré par un filtre d'identification à réponse impulsionnelle finie représentative de la réponse dudit système, et on adapte les coefficients du filtre d'identification en tenant compte du signal d'entrée, du signal d'erreur et d'un pas d'adaptation. Selon l'invention, on fait varier la valeur du pas d'adaptation $\mu_t$ selon :

$$\mu_t = \frac{a}{c+d.P2_t/P1_t} \tag{3}$$

où a, c et d désignent des constantes positives, $P1_t$ désigne une estimation à l'instant considéré de la puissance du signal d'entrée et $P2_t$ désigne une estimation à l'instant considéré de la puissance du signal d'observation ou d'une composante de perturbation dudit signal d'observation.

L'expression (3) permet d'ajuster de façon automatique le pas d'adaptation $\mu_t$ aux conditions de bruit auxquelles est soumis le système.

Si l'on suppose le bruit additif, le signal d'observation est donné par la somme du signal de sortie du système à identifier et du bruit d'observation. Si $P2_t$ est la puissance du signal d'observation, l'expression (3) permet d'obtenir une valeur proche de $a/(c+d\gamma)$, où $\gamma$ est un majorant du module au carré de la fonction de transfert du système à identifier, lorsque la puissance du bruit ou de la perturbation est faible devant celle du signal d'entrée (et donc devant celle du signal de sortie), et inversement une valeur d'autant plus proche de 0 que le niveau de bruit est important (le filtre d'identification doit être faiblement adapté en présence de bruit important). Si $P2_t$ est la puissance de la composante de perturbation, l'expression (3) fournit un valeur $\mu$ proche de $a/c$ lorsque la puissance du bruit ou de la perturbation est faible devant celle du signal d'entrée, et une valeur proche de 0 lorsque le niveau de bruit est important. En pratique, les constantes a, c et d sont choisies de sorte que la plage de variation du pas d'adaptation corresponde au domaine de stabilité de l'algorithme utilisé. Dans le cas, par exemple, de l'utilisation du NLMS sur du bruit blanc, le choix a=c permet d'obtenir un pas d'adaptation proche de 1 (valeur optimale pour la convergence dans ce cas) lorsque la puissance du bruit d'observation est faible devant celle du signal d'entrée du système à identifier.

Lorsque l'algorithme d'adaptation utilisé tient compte d'un facteur d'oubli on peut également, selon l'invention, faire varier ce facteur d'oubli $\lambda_t$ selon

$$\lambda_t = 1 - \frac{\mu_t}{\alpha L} \qquad (4)$$

où $\mu_t$ désigne le pas d'adaptation variable et $\alpha L$ désigne une constante positive.

Lorsque l'algorithme d'adaptation ne tient pas explicitement compte d'un pas d'adaptation mais seulement d'un facteur d'oubli $\lambda_t$, celui-ci peut avoir une valeur qu'on fait varier conformément à une relation correspondant à une concaténation des formules (3) et (4), soit :

$$\lambda_t = 1 - \left( \frac{a}{c + d \cdot P2_t / P1_t} \right) / \alpha L. \qquad (5)$$

L'expression (4) ou (5) permet elle aussi d'ajuster de façon automatique le facteur d'oubli $\lambda_t$ de l'algorithme aux conditions de bruit d'observation.

Ainsi, ce facteur d'oubli tend vers $[1-a/((c+d\gamma)\alpha L)]$ (ou vers $[1-a/c\alpha L]$), lorsque la puissance de bruit est faible devant celle du signal d'entrée, et inversement vers 1 lorsque le niveau de bruit croît. Ce dernier aspect peut s'expliquer par le manque de fiabilité des estimateurs d'énergie à court terme en présence de bruit important et donc par la nécessité d'accroître la mémoire de ces estimateurs pour exploiter des informations à plus long terme.

Un second aspect de l'invention concerne un dispositif d'identification adaptative d'un système auquel est appliqué un signal d'entrée comprenant :

- une première entrée recevant le signal d'entrée ;
- une seconde entrée recevant un signal d'observation dont une composante est une réponse dudit système au signal d'entrée ;
- un filtre d'identification à réponse impulsionnelle finie représentative de la réponse dudit système ;
- un soustracteur produisant un signal d'erreur en soustrayant du signal d'observation le signal d'entrée filtré par le filtre d'identification ;
- des moyens d'adaptation des coefficients du filtre d'identification en fonction du signal d'entrée, du signal d'erreur et d'un pas d'adaptation et/ou d'un facteur d'oubli ;
- des premiers moyens d'estimation de la puissance du signal d'entrée;
- des seconds moyens d'estimation de la puissance du signal d'observation ou d'une composante de perturbation dudit signal d'observation ; et
- des moyens de calcul du pas d'adaptation et/ou du facteur d'oubli fourni(s) aux moyens d'adaptation.

Si l'adaptation fait appel à un pas d'adaptation $\mu_t$, celui-ci varie selon la formule (3) ci-dessus. Si l'adaptation fait appel à un facteur d'oubli $\lambda_t$, celui-ci varie selon la formule (4) ou (5) ci-dessus.

Un tel dispositif peut notamment faire partie d'un annuleur d'écho adaptatif. Un annuleur d'écho adaptatif enlève d'un signal de retour des composantes d'écho d'un signal direct. La première entrée du dispositif d'identification adaptative reçoit le signal direct en tant que signal d'entrée, tandis que la seconde entrée reçoit le signal de retour. Le signal d'erreur constitue le signal de sortie de l'annuleur d'écho.

D'autres particularités et avantages de la présente invention apparaîtront dans la description ci-après d'exemples de réalisation préférés mais non limitatifs, en référence aux dessins annexés, dans lesquels :

- la figure 1 est un schéma synoptique d'un dispositif d'identification adaptative selon l'invention ;
- la figure 2 est un schéma synoptique d'un annuleur d'écho adaptatif selon l'invention.

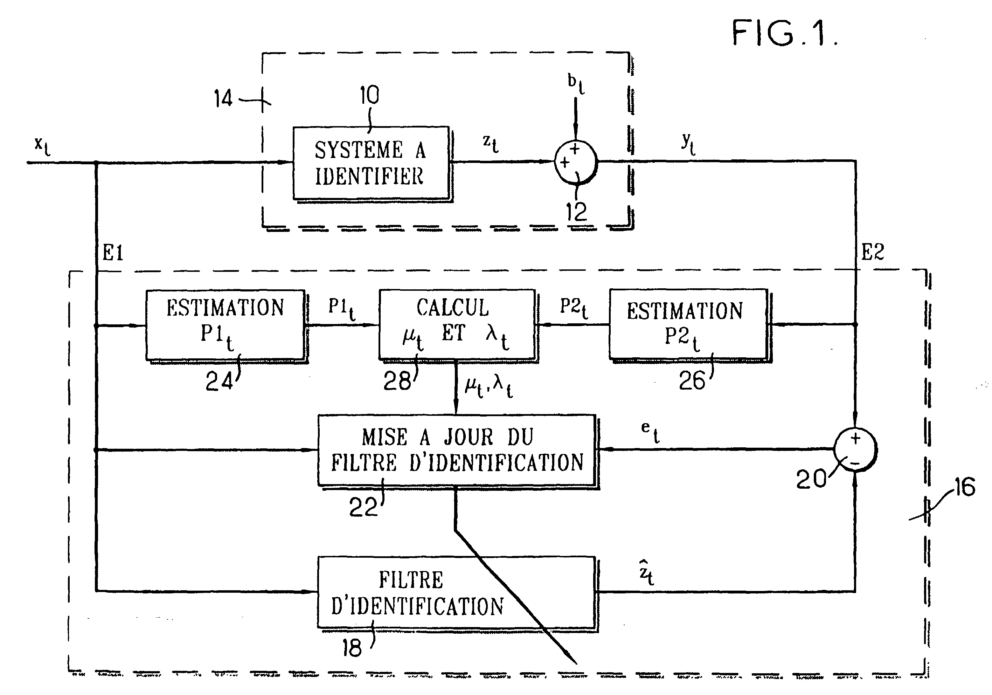

La figure 1 montre un système à identifier 10 auquel est appliqué un signal $x_t$ variant dans le temps. On note $z_t$ la réponse du système 10 au signal d'entrée $x_t$. La mesure de la réponse $z_t$ s'accompagne inévitablement de l'adjonction d'une composante de perturbation $b_t$ appelée bruit d'observation. Ce bruit d'observation $b_t$ peut comprendre du bruit à proprement parler (bruit blanc ou bruit routier par exemple), mais également du signal utile. La composante $b_t$ est appelée bruit d'observation dans la mesure où elle perturbe l'observation de la réponse $z_t$. L'additionneur 12 symbolise sur la figure l'adjonction de la composante de perturbation $b_t$, supposée additive, à la réponse $z_t$. Le signal d'observation mesuré $y_t$ est ainsi la réponse d'un système réel 14 incluant le système à identifier 10 et l'additionneur 12.

Le dispositif d'identification adaptative 16 reçoit le signal d'entrée $x_t$ sur une première entrée E1, et le signal d'observation $y_t$ sur une seconde entrée E2. Les signaux $x_t$ et $y_t$ sont amplifiés, filtrés et numérisés à l'entrée du dispositif 16 par des éléments classiques non représentés.

Le dispositif d'identification adaptative 16 comporte un filtre d'identification 18 consistant en un filtre programmable à réponse impulsionnelle finie. Les coefficients du filtre d'identification 18 sont adaptés pour que ce filtre soit représentatif de la réponse du système à identifier 10. Le filtre 18 reçoit le signal d'entrée numérisé $x_t$, et délivre une estimation $\hat{z}_t$ de la réponse $z_t$ du système 10.

Un soustracteur 20 retranche cette estimation $\hat{z}_t$ du signal d'observation numérisé $y_t$ pour fournir un signal d'erreur et. Ce signal d'erreur et peut être vu comme une estimation de la composante de perturbation $b_t$.

Une unité 22 de mise à jour du filtre d'identification adapte les coefficients du filtre 18 sur la base du signal d'entrée $x_t$ et du signal d'erreur et. L'unité 22 prend en compte pour l'adaptation un pas d'adaptation $\mu_t$, et/ou un facteur d'oubli $\lambda_t$. Conformément à l'invention, le pas d'adaptation $\mu_t$ et, le cas échéant, le facteur d'oubli $\lambda_t$ sont variables en fonction du signal d'entrée et du signal d'observation.

Le dispositif d'identification adaptative 16 comporte une unité 24 qui calcule une estimation $P1_t$ de la puissance du signal d'entrée $x_t$, et une unité 26 qui calcule une estimation $P2_t$ soit de la puissance du signal d'observation $y_t$, soit de la puissance de la composante de perturbation $b_t$ du signal d'observation $y_t$. Une unité 28 calcule le pas d'adaptation $\mu_t$ et, le cas échéant, le facteur d'oubli $\lambda_t$ en fonction des estimations de puissance $P1_t$ et $P2_t$, et les fournit à l'unité 22 de mise à jour du filtre d'identification. Le pas d'adaptation $\mu_t$ est calculé selon la formule:

$$\mu_t = \frac{a}{c + d.P2_t/P1_t}$$

où a, c et d désignent des constantes positives.

Si l'algorithme de mise à jour mise en oeuvre par l'unité 22 fait appel à un facteur d'oubli $\lambda_t$, celui-ci est calculé par l'unité 28 selon la formule :

$$\lambda_t = 1 - \frac{\mu_t}{\alpha L}$$

où $\alpha L$ désigne une constante positive égale au produit d'un coefficient $\alpha$ par la longueur L, exprimée en nombres d'échantillons, de la réponse impulsionnelle du filtre d'identification 18 utilisé.

L'unité 22 de mise à jour du filtre d'identification met par exemple en oeuvre l'algorithme du gradient stochastique normalisé (NLMS) dont les équations (1) et (2bis) ont été rappelées en introduction. Un autre exemple d'algorithme d'adaptation utilisable est l'algorithme de projection affine (APA) d'ordre 2, dont les équations sont :

$$U_{L,t} = X_{L,t} - \frac{\langle X_{L,t}, X_{L,t-1} \rangle}{\| X_{L,t-1} \|^2} \tag{6}$$

$$H_{L,t} = H_{L,t-1} + \mu_t \left[ \frac{e_t}{\langle U_{L,t}, X_{L,t} \rangle} \right] U_{L,t} \tag{7}$$

Le pas d'adaptation variable et/ou le facteur d'oubli variable peuvent également être utilisés avec divers autres algorithmes d'adaptation pouvant être mis en oeuvre par l'unité 22.

Le facteur d'oubli $\lambda_t$, lorsqu'il est utilisé, sert généralement au calcul de produits scalaires tels que par exemple ceux prévus dans l'équation (6) dans le cas de l'algorithme APA d'ordre 2. Les produits scalaires sont alors calculés de façon récursive sur une fenêtre exponentielle caractérisée par la valeur du facteur d'oubli :

$$\langle X_{L,t}, X_{L,t-1} \rangle = \lambda_t \langle X_{L,t-1}, X_{L,t-2} \rangle + x_t x_{t-1} \tag{8}$$

ou

$$<X_{L,t},X_{L,t-1}> = \lambda_t <X_{L,t-1},X_{L,t-2}> + (1-\lambda_t)x_t\, x_{t-1} \tag{8bis}$$

et

$$\|X_{L,t-1}\|^2 = \lambda_t\|X_{L,t-2}\|^2 + x_{t-1}^{\;2} \tag{9}$$

ou

$$\|X_{L,t-1}\|^2 = \lambda_t\|X_{L,t-2}\|^2 + (1-\lambda_t)\, x_{t-1}^{\;2} \tag{9bis}$$

L'expression (9) ou (9bis) peut également être utilisée pour calculer $\|X_{L,t}\|^2$ (équation (2bis)) dans le cas de l'algorithme NLMS. La valeur du coefficient $\alpha$ servant au calcul du facteur d'oubli variable $\lambda_t$ dépend de l'algorithme d'adaptation utilisé. La valeur $\alpha=1$ convient en général pour les algorithmes de type gradient ou de projection, tandis que $\alpha=3$ convient pour les algorithmes de type MCRR.

Un exemple d'algorithme d'adaptation mettant en oeuvre uniquement le facteur d'oubli variable $\lambda_t$ (défini par l'équation (5) avec $\alpha=3$) est l'algorithme RLS (Recursive Least Squares ou MCR pour Moindres Carrés Récursifs) à oubli exponentiel donné par les équations (10) à (15) suivantes :

.   Initialisation :

$$R_{L,0}^{-1} = c.I_L$$

c étant un réel positif et IL la matrice identité de dimension LxL.
.   Acquisition de $x_t$ et $y_t$ ; mémorisation de $x_t$
.   Calcul du gain de Kalman :

-   Calcul d'un vecteur $K_{L,t}$ et d'un scalaire $k_{L,t}$ intermédiaires :

$$K_{L,t} = R_{L,t-1}^{-1}.X_{L,t} \tag{10}$$

$$k_{L,t} = \lambda_t + <K_{L,t},X_{L,t}> \tag{11}$$

-   Calcul du gain de Kalman :

$$C_{L,t} = -\frac{1}{k_{L,t}}\, K_{L,t} \tag{12}$$

.   Mise à jour de l'inverse de la matrice d'autocorrélation :

$$R_{L,t}^{-1} = \frac{1}{\lambda_t}\left(R_{L,t-1}^{-1} - \frac{1}{k_{L,t}}\|K_{L,t}\|^2\right) \tag{13}$$

.   Filtrage :

$$e_t = y_t - <H_{L,t-1},X_{L,t}> \tag{14}$$

.   Adaptation :

$$H_{L,t} = H_{L,t-1} - e_t \cdot C_{L,t} \tag{15}$$

Bien qu'on ait fait référence ci-dessus à des algorithmes temporels, l'invention est également applicable avec des algorithmes fréquentiels, c'est-à-dire dans lesquels les signaux sont convertis dans le domaine fréquentiel (par exemple par transformée de Fourier), filtrés dans le domaine fréquentiel par un filtre programmable, puis ramenés dans le domaine temporel par transformée de Fourier inverse. Dans ce cas, les signaux d'entrée $x_t$ correspondent à des composantes fréquentielles du signal d'origine obtenues par transformée de Fourier ou filtrage en sous-bande, et les puissances $P1_t$, $P2_t$ représentent les puissances correspondantes. On note que les coefficients $\mu_t$ et/ou $\lambda_t$ ainsi obtenus sont généralement différents à l'égard des différentes composantes fréquentielles.

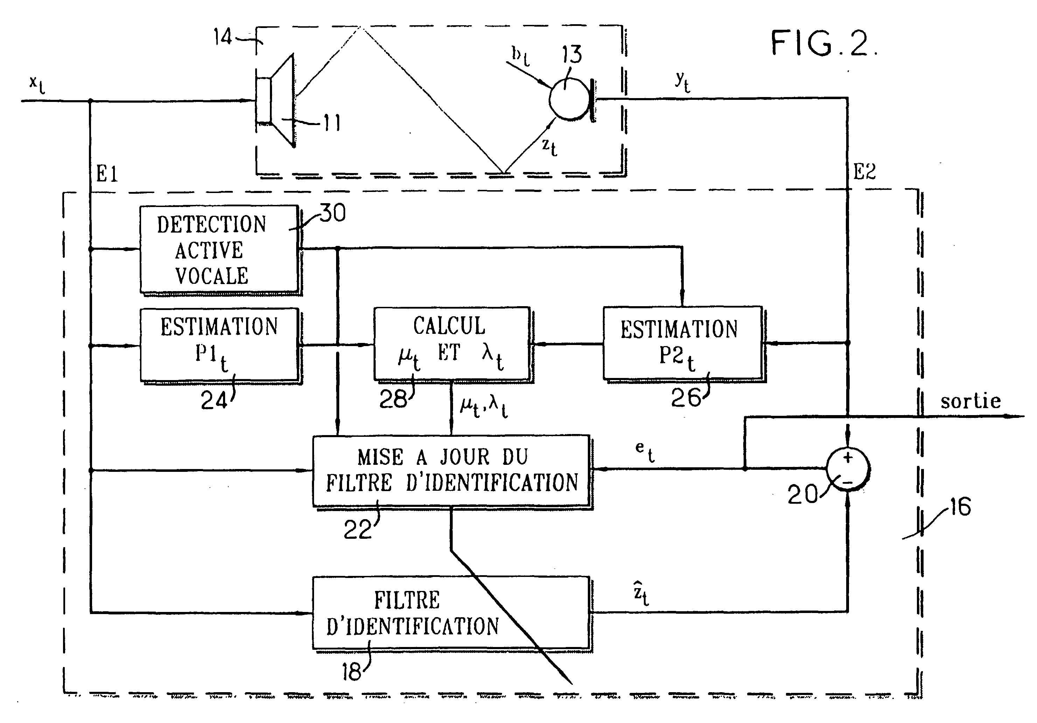

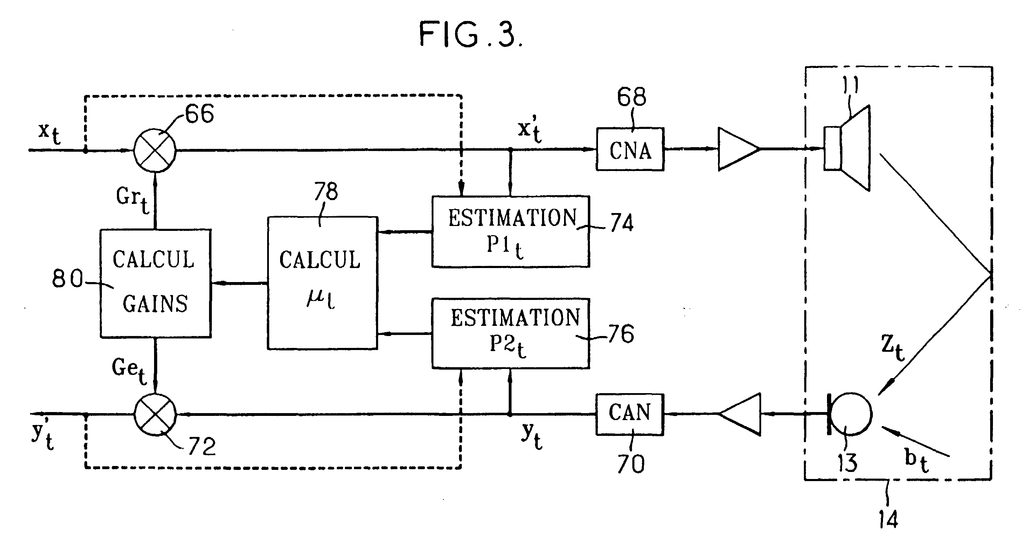

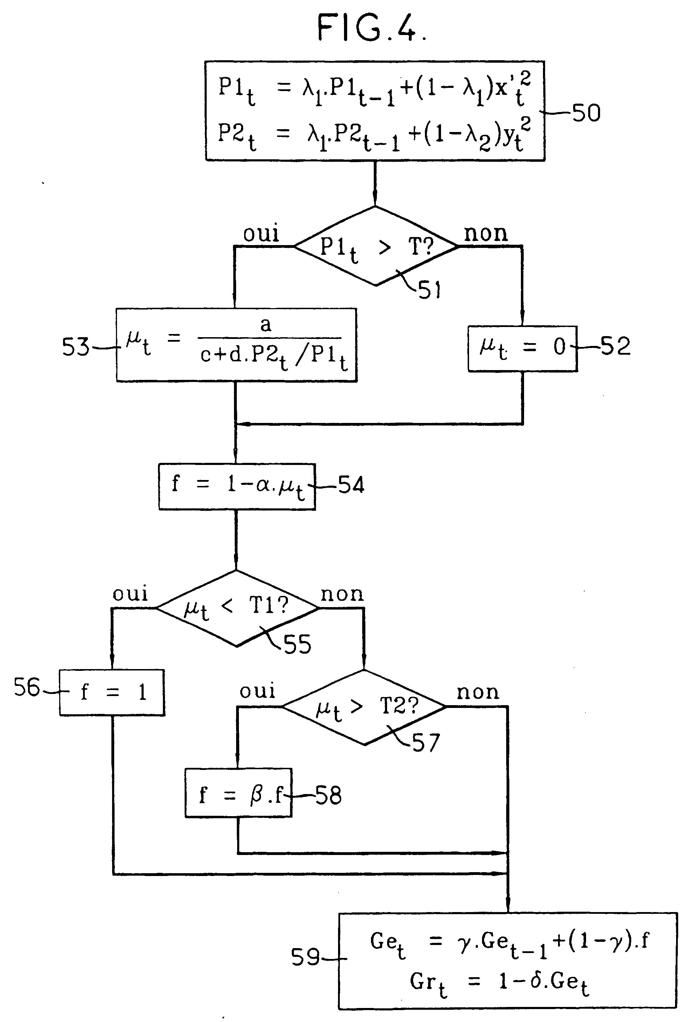

La figure 2 montre un annuleur d'écho adaptatif incorporant un dispositif d'identification adaptative 16 du type décrit en référence à la figure 1. L'annuleur d'écho est associé à une installation téléphonique mains-libres. Le signal d'entrée $x_t$ est le signal direct destiné au haut-parleur 11 de l'installation mains-libres. Le signal d'observation $y_t$ est le signal de retour recueilli par le microphone 13 de l'installation mains-libres. Ce signal d'observation $y_t$ inclut des composantes d'écho $z_t$ du signal direct, et des composantes de perturbation $b_t$ pouvant inclure du bruit et de la parole émise par le locuteur. Le système à identifier consiste en le ou les trajets d'écho entre le haut-parleur 11 et le microphone 13.

Dans son application à un annuleur d'écho adaptatif, le système d'identification adaptative 16 comporte un détecteur d'activité vocale 30 qui indique si le signal direct $x_t$ est vocalement actif ou inactif. De tels détecteurs d'activité vocale sont classiquement utilisés dans les annuleurs d'écho. L'unité 22 ne procède à la mise à jour du filtre d'identification 18 que lorsque le signal direct $x_t$ supporte une activité vocale.

Pour estimer la puissance $P1_t$ du signal d'entrée $x_t$, l'unité 24 utilise une fenêtre exponentielle dont la constante de temps est liée à la grandeur $\gamma = 1-1/L$ :

$$P1_t = \gamma \cdot P1_{t-1} + x_t^2 \tag{16}$$

ou

$$P1_t = \gamma \, P1_{t-1} + (1-\gamma)x_t^2 \tag{16bis}$$

où $x_t$ représente l'échantillon du signal d'entrée à l'instant t.

La même fenêtre exponentielle peut être utilisée par l'unité 26 pour calculer l'estimation $P2_t$. Si $P2_t$ représente une estimation de la puissance du signal d'observation, celle-ci est donnée par

$$P2_t = \gamma \cdot P2_{t-1} + y_t^2 \tag{17}$$

ou

$$P2_t = \gamma \cdot P2_{t-1} + (1-\gamma)y_t^2 \tag{17bis}$$

où $y_t$ est l'échantillon du signal de retour à l'instant t. Si l'estimation $P2_t$ représente la puissance de la composante de perturbation du signal d'observation, l'unité 26 met en oeuvre la même formule (17) ou (17bis), mais uniquement aux instants où le détecteur d'activité vocale 30 indique que le signal direct est vocalement inactif.

L'annuleur d'écho ci-dessus a l'avantage d'être relativement robuste à l'égard du phénomène de double parole (cas où la parole locale se superpose au signal d'écho). La situation de double parole conduit à augmenter l'estimation de puissance $P2_t$, et donc à diminuer la valeur du pas d'adaptation $\mu_t$. L'ajustement automatique du pas d'adaptation $\mu_t$ permet ainsi de limiter l'importance de l'adaptation en situation de double parole, sans qu'il soit indispensable de détecter spécialement ces situations de double parole. Les essais effectués en laboratoire ont pu confirmer les bonnes performances de l'annuleur d'écho en situation de double parole.

En pratique, cet annuleur d'écho peut être réalisé en programmant un processeur spécialisé pour le traitement du signal (DSP) comme il est usuel. Il peut être également réalisé au moyen d'un circuit intégré spécifique (ASIC) dédié à cette application.

Les inventeurs ont pu vérifier l'amélioration des performances que procure le procédé d'identification adaptative selon l'invention dans un annuleur d'écho. Par exemple, en faisant varier le pas d'adaptation $\mu_t$ et le facteur d'oubli $\lambda_t$ selon les relations (3) et (4), avec $P2_t$ représentant la puissance de la composante de perturbation du signal d'observation, et avec le choix de paramètres a=c=20, d=L=256 pour une fréquence d'échantillonnage de 8kHz, on peut observer que l'algorithme APA d'ordre 2 fournit une augmentation significative de l'atténuation de l'écho (ERLE : " Echo Return Loss Enhancement") par rapport au même algorithme utilisant un pas d'adaptation fixe, particulièrement en présence d'un fort bruit environnant. Les inventeurs ont également vérifié qu'on obtient une moindre perturbation des performances de l'annuleur d'écho en situation de double parole qu'en utilisant un pas d'adaptation fixe. Ceci peut par exemple être observé avec l'algorithme APA d'ordre 2 en faisant varier le pas d'adaptation $\mu_t$ et le facteur d'oubli $\lambda_t$ selon les relations (3) et (4), avec $P2_t$ représentant la puissance du signal d'observation, et avec le choix de paramètres a=2,5, c=10, d=80, L=256 pour une fréquence d'échantillonnage de 8 kHz.

Le procédé et le dispositif d'identification adaptative selon l'invention permettent d'améliorer les performances des systèmes d'identification adaptative en environnement bruité. La technique présentée résout la problématique fréquemment posée par le choix des paramètres pour le contrôle de ces systèmes dans des environnements dont les caractéristiques du bruit varient au cours du temps. Parmi ces environnements fréquemment rencontrés en pratique, on peut citer la variation du niveau de bruit capté à l'intérieur d'un véhicule lorsque ses vitres sont ouvertes ou fermées ou bien encore lors d'un croisement d'un véhicule en sens inverse.

Il est important de noter que ce choix de paramètres était, jusqu'à présent, réalisé de manière empirique en laboratoire et en considérant les conditions les plus adverses. L'invention constitue une avancée considérable dans la mesure où ces mêmes paramètres sont ajustés automatiquement et de manière adaptative en fonction des conditions de bruits rencontrées.

Ce dispositif permet en outre d'accroître significativement les performances de ces systèmes d'identification en situation de double parole, ce qui simplifie de façon considérable les mécanismes de contrôle associés à ces systèmes d'identification.

D'autre part, bien que le procédé et le dispositif d'identification adaptative selon l'invention aient été décrits dans leur application à l'annulation d'écho acoustique dans le contexte des radiocommunications avec les mobiles, ils peuvent également être utilisés dans tout système d'identification adaptative (égalisation de canaux de propagation, annulation d'écho électrique pour la téléphonie, commandes automatiques de procédé pour la gestion de production,...).

La pluralité des domaines d'application de l'invention décrite ci-avant ne fait qu'accroître son avantage majeur, à savoir l'amélioration très significative des performances des systèmes d'identification adaptative obtenue par un dispositif automatique et adaptatif, et ce au sein d'environnements dont les caractéristiques de bruit varient au cours du temps.

**Revendications**

1. Procédé d'identification adaptative pour estimer la réponse d'un système (10) à un signal d'entrée ($x_t$), dans lequel on reçoit d'une part le signal d'entrée et d'autre part un signal d'observation ($y_t$) dont une composante est ladite réponse au signal d'entrée, on détermine un signal d'erreur ($e_t$) en soustrayant du signal d'observation le signal d'entrée filtré par un filtre d'identification (18) à réponse impulsionnelle finie représentative de la réponse dudit système, et on adapte les coefficients du filtre d'identification en tenant compte du signal d'entrée, du signal d'erreur et d'un pas d'adaptation, **caractérisé en ce qu'**on fait varier la valeur du pas d'adaptation $\mu_t$ selon :

$$\mu_t = \frac{a}{c+d.P2_t/P1_t}$$

où a, c et d désignent des constantes positives, $P1_t$ désigne une estimation à l'instant considéré de la puissance du signal et $P2_t$ désigne une estimation à l'instant considéré de la puissance du signal d'observation ou d'une composante de perturbation dudit signal d'observation.

2. Procédé selon la revendication 1, **caractérisé en ce que** l'adaptation des coefficients du filtre d'identification (18) tient compte d'un facteur d'oubli variable $\lambda_t$ de la forme :

$$\lambda_t = 1 - \frac{\mu_t}{\alpha L}$$

où $\mu_t$ désigne le pas d'adaptation variable et $\alpha L$ désigne une constante positive.

**3.** Procédé d'identification adaptative pour estimer la réponse d'un système (10) à un signal d'entrée ($x_t$), dans lequel on reçoit d'une part le signal d'entrée et d'autre part un signal d'observation ($y_t$) dont une composante est ladite réponse au signal d'entrée, on détermine un signal d'erreur ($e_t$) en soustrayant du signal d'observation le signal d'entrée filtré par un filtre d'identification (18) à réponse impulsionnelle finie représentative de la réponse dudit système, et on adapte les coefficients du filtre d'identification en tenant compte du signal d'entrée, du signal d'erreur et d'un facteur d'oubli, **caractérisé en ce qu'**on fait varier la valeur du facteur d'oubli $\lambda_t$ selon :

$$\lambda_t = 1 - \left( \frac{a}{c + d \cdot P2_t / P1_t} \right) / \alpha L$$

où a, c, d et $\alpha L$ désignent des constantes positives, $P1_t$ désigne une estimation à l'instant considéré de la puissance du signal d'entrée et $P2_t$ désigne une estimation à l'instant considéré de la puissance du signal d'observation ou d'une composante de perturbation dudit signal d'observation.

**4.** Dispositif d'identification adaptative d'un système (10) auquel est appliqué un signal d'entrée ($x_t$), comprenant :

- une première entrée (E1) recevant le signal d'entrée ;
- une seconde entrée (E2) recevant un signal d'observation ($y_t$) dont une composante est une réponse dudit système au signal d'entrée ;
- un filtre d'identification (18) à réponse impulsionnelle finie représentative de la réponse dudit système ;
- un soustracteur (20) produisant un signal d'erreur ($e_t$) en soustrayant du signal d'observation le signal d'entrée filtré par le filtre d'identification ; et
- des moyens (22) d'adaptation des coefficients du filtre d'identification en fonction du signal d'entrée, du signal d'erreur et d'un pas d'adaptation,

   **caractérisé en ce qu'**il comprend en outre :

- des premiers moyens (24) d'estimation de la puissance ($P1_t$) du signal d'entrée;
- des seconds moyens (26) d'estimation de la puissance ($P2_t$) du signal d'observation ou d'une composante de perturbation dudit signal d'observation ; et
- des moyens (28) de calcul du pas d'adaptation fourni aux moyens d'adaptation (22), le pas d'adaptation $\mu_t$ variant selon la formule :
où a, c et d désignent des constantes positives, $P1_t$ est

$$\mu_t = \frac{a}{c + d \cdot P2_t / P1_t}$$

l'estimation de puissance fournie par les premiers moyens d'estimation (24) et $P2_t$ est l'estimation de puissance fournie par les seconds moyens d'estimation (26).

**5.** Dispositif selon la revendication 4, **caractérisé en ce que** les moyens (22) d'adaptation des coefficients du filtre d'identification tiennent compte d'un facteur d'oubli variable $\lambda_t$ calculé par les moyens de calcul (28) selon :

$$\lambda_t = 1 - \frac{\mu_t}{\alpha L}$$

où $\mu_t$ désigne le pas d'adaptation variable et $\alpha L$ désigne une constante positive.

**6.** Dispositif d'identification adaptative d'un système (10) auquel est appliqué un signal d'entrée ($x_t$), comprenant :

- une première entrée (E1) recevant le signal d'entrée ;
- une seconde entrée (E2) recevant un signal d'observation ($y_t$) dont une composante est une réponse dudit système au signal d'entrée ;

- un filtre d'identification (18) à réponse impulsionnelle finie représentative de la réponse dudit système ;
- un soustracteur (20) produisant un signal d'erreur ($e_t$) en soustrayant du signal d'observation le signal d'entrée filtré par le filtre d'identification ; et
- des moyens (22) d'adaptation des coefficients du filtre d'identification en fonction du signal d'entrée, du signal d'erreur et d'un facteur d'oubli,

   **caractérisé en ce qu'**il comprend en outre :

- des premiers moyens (24) d'estimation de la puissance ($P1_t$) du signal d'entrée;
- des seconds moyens (26) d'estimation de la puissance ($P2_t$) du signal d'observation ou d'une composante de perturbation dudit signal d'observation ; et
- des moyens (28) de calcul du facteur d'oubli fourni aux moyens d'adaptation (22), le facteur d'oubli $\lambda_t$ variant selon la formule :

$$\lambda_t = 1 - \left(\frac{a}{c+d.P2_t/P1_t}\right)/\alpha L$$

où a, c, d et $\alpha L$ désignent des constantes positives, $P1_t$ est l'estimation de puissance fournie par les premiers moyens d'estimation (24) et $P2_t$ est l'estimation de puissance fournie par les seconds moyens d'estimation (26).

**7.** Annuleur d'écho adaptatif pour enlever d'un signal de retour ($y_t$) des composantes d'écho d'un signal direct ($x_t$), **caractérisé en ce qu'**il comprend un dispositif d'identification (16) conforme à l'une quelconque des revendications 4 à 6, dont la première entrée (E1) reçoit le signal direct ($x_t$) en tant que signal d'entrée et dont la seconde entrée (E2) reçoit le signal de retour ($y_t$) en tant que signal d'observation, le signal d'erreur ($e_t$) constituant le signal de sortie de l'annuleur d'écho.

**Patentansprüche**

**1.** Verfahren zur adaptiven Identifikation zum Schätzen der Antwort eines Systems (10) auf ein Eingangssignal ($x_t$), bei welchem man einerseits das Eingangssignal und andererseits ein Observationssignal ($y_t$) empfängt, von dem eine Komponente die Antwort auf das Eingangssignal ist, bei welchem man ein Fehlersignal ($e_t$) bestimmt, indem man von dem Observationssignal das durch ein Identifikationsfilter (18) mit begrenzter Impulsantwort, die für die Antwort des Systems repräsentativ ist, gefilterte Eingangssignal subtrahiert, und bei welchem man die Koeffizienten des Identifikationsfilters unter Berücksichtigung des Eingangssignals, des Fehlersignals und eines Adaptionsschrittes adaptiert, **dadurch gekennzeichnet, dass** man den Wert des Adaptionsschrittes $\mu_t$ variiert gemäß:

$$\mu_t = \frac{a}{c+d.P2_t/P1_t}$$

wobei a, c und d positive Konstanten bezeichnen, $P1_t$ eine Schätzung der Leistung des Eingangssignals zu dem in Betracht gezogenen Zeitpunkt bezeichnet und $P2_t$ eine Schätzung der Leistung des Observationssignats oder einer Störkomponente des Observationssignals zu dem in Betracht gezogenen Zeitpunkt bezeichnet.

**2.** Verfahren nach Anspruch 1, **dadurch gekennzeichnet, dass** die Adaption der Koeffizienten des Identifikationsfilters (18) einen variablen Auslassungsfaktor $\lambda_t$ der Formel:

$$\lambda_t = 1 - \frac{\mu_t}{\alpha L}$$

berücksichtigt, wobei $\mu_t$ den variablen Adaptionsschritt und $\alpha L$ eine positive Konstante bezeichnet.

3. Verfahren zur adaptiven Identifikation zum Schätzen der Antwort eines Systems (10) auf ein Eingangssignal ($x_t$), bei welchem man einerseits das Eingangssignal und andererseits ein Observationssignal ($y_t$) empfängt, von dem eine Komponente die genannte Antwort auf das Eingangssignal ist, bei welchem man ein Fehlersignal ($e_t$) bestimmt, indem man von dem Observationssignal das durch ein Identifikationsfilter (18) mit begrenzter Impulsantwort, die für die Antwort des Systems repräsentativ ist, gefilterte Eingangssignal subtrahiert, und bei welchem man die Koeffizienten des Identifikationsfilters unter Berücksichtigung des Eingangssignals, des Fehlersignals und eines Auslassungsfaktors adaptiert, **dadurch gekennzeichnet, dass** man den Wert des Auslassungsfaktors $\lambda_t$ variiert gemäß:

$$\lambda_t = 1 - \left( \frac{a}{c + d.P2_t / P1_t} \right) / \ \alpha L$$

wobei a, c, d und $\alpha L$ positive Konstanten bezeichnen, $P1_t$ eine Schätzung der Leistung des Eingangssignals zu dem in Betracht gezogenen Zeitpunkt bezeichnet und $P2_t$ eine Schätzung der Leistung des Observationssignals oder einer Störkomponente des Observationssignals zu dem in Betracht gezogenen Zeitpunkt bezeichnet.

4. Vorrichtung zur adaptiven Identifikation eines Systems (10), an welches ein Eingangssignal ($x_t$) angelegt wird, umfassend:

- einen ersten Eingang (E1), der das Eingangssignal empfängt;
- einen zweiten Eingang (E2), der ein Observationssignal ($y_t$) empfängt, von dem eine Komponente eine Antwort des Systems auf das Eingangssignal ist;
- ein Identifikationsfilter (18) mit begrenzter Impulsantwort, die repräsentativ ist für die Antwort des Systems;
- ein Subtrahierglied (20), das ein Fehlersignal ($e_t$) produziert, indem es das durch das Identifikationsfilter gefilterte Eingangssignal von dem Observationssignal subtrahiert; und
- Mittel (22) zur Anpassung der Koeffizienten des Identifikationsfilters abhängig von dem Eingangssignal, dem Fehlersignal und einem Adaptionsschritt,

**dadurch gekennzeichnet, dass** sie ferner umfasst:

- erste Mittel (24) zum Schätzen der Leistung ($P1_t$) des Eingangssignals;
- zweite Mittel (26) zum Schätzen der Leistung ($P2_t$) des Observationssignals oder einer Störkomponente des Observationssignals; und
- Mittel (28) zur Berechnung des Adaptionsschrittes, der an die Adaptionsmittel (22) geliefert wird, wobei der Adaptionsschritt $\mu_t$ gemäß der Formel

$$\mu_t = \frac{a}{c + d.P2_t / P1_t}$$

variiert, in der a, c und d positive Konstanten bezeichnen, $P1_t$ die von den ersten Schätzmitteln (24) gelieferte Leistungsschätzung ist und $P2_t$ die von den zweiten Schätzmitteln (26) gelieferte Leistungsschätzung ist.

5. Vorrichtung nach Anspruch 4, **dadurch gekennzeichnet, dass** die Mittel (22) zur Adaption der Koeffizienten des Identifikationsfilters einen variablen Auslassungsfaktor $\lambda_t$ berücksichtigen, der durch die Berechnungsmittel (28) berechnet wird gemäß:

$$\lambda_t = 1 - \frac{\mu_t}{\alpha L}$$

wobei $\mu_t$ den variablen Adaptionsschritt und $\alpha L$ eine positive Konstante bezeichnet.

6. Vorrichtung zur adaptiven Identifikation eines Systems (10), an welches ein Eingangssignal ($x_t$) angelegt wird, umfassend:

- einen ersten Eingang (E1), der das Eingangssignal empfängt;
- einen zweiten Eingang (E2), der ein Observationssignal ($y_t$) empfängt, von dem eine Komponente eine Antwort des Systems auf das Eingangssignal ist;
- ein Identifikationsfilter (18) mit begrenzter Impulsantwort, die repräsentativ ist für die Antwort des Systems;
- ein Subtrahierglied (20), das ein Fehlersignal ($e_t$) produziert, indem es das durch das Identifikationsfilter gefilterte Eingangssignal von dem Observationssignal subtrahiert; und
- Mittel (22) zur Adaption der Koeffizienten des Identifikationsfilters abhängig von dem Eingangssignal, dem Fehlersignal und einem Auslassungsfaktor,

**dadurch gekennzeichnet, dass** sie ferner umfasst:

- erste Mittel (24) zum Schätzen der Leistung ($P1_t$) des Eingangssignals;
- zweite Mittel (26) zum Schätzen der Leistung ($P2_t$) des Observationssignals oder einer Störkomponente des Observationssignals; und
- Mittel (28) zur Berechnung des Auslassungsfaktors, der an die Adaptionsmittel (22) geliefert wird, wobei der Auslassungsfaktor $\lambda_t$ gemäß der Formel

$$\lambda_t = 1 - \left( \frac{a}{c + d.P2_t / P1_t} \right) / \; \alpha L$$

variiert, in der a, c, d und $\alpha L$ positive Konstanten bezeichnen, $P1_t$ die von den ersten Schätzmitteln (24) gelieferte Leistungsschätzung ist und $P2_t$ die von den zweiten Schätzmitteln (26) gelieferte Leistungsschätzung ist.

7. Adaptiver Echokompensator zum Beseitigen von Echokomponenten eines direkten Signals ($x_t$) aus einem Rückmeldesignal ($y_t$), **dadurch gekennzeichnet, dass** er eine Identifikationsvorrichtung (16) entsprechend einem der Ansprüche 4 bis 6 umfasst, deren erster Eingang (E1) das direkte Signal ($x_t$) als Eingangssignal empfängt und deren zweiter Eingang (E2) das Rückmeldesignal ($y_t$) als Observationssignal empfängt, wobei das Fehlersignal ($e_t$) das Ausgangssignal des Echokompensators bildet.

## Claims

1. Process of adaptive identification for estimating the response of a system (10) to an input signal ($x_t$), which comprises receiving on the one hand the input signal and on the other hand an observation signal ($y_t$), a component of which is said response to the input signal, determining an error signal ($e_t$) by subtracting from the observation signal the input signal filtered by an identification filter (18) with finite impulse response representative of the response of said system, and adapting the coefficients of the identification filter by taking into account the input signal, the error signal and an adaptation stepsize, **characterized in that** the value of the adaptation stepsize $\mu_t$ is varied according to:

$$\mu_t = \frac{a}{c + d.P2_t/P1_t}$$

where a, c and d denote positive constants, $P1_t$ denotes an estimate at the relevant instant of the power of the input signal and $P2_t$ denotes an estimate at the relevant instant of the power of the observation signal or of a disturbance component of said observation signal.

2. Process according to Claim 1, **characterized in that** the adaptation of the coefficients of the identification filter (18) takes into account a variable forgetting factor $\lambda_t$ of the form:

$$\lambda_t = 1 - \frac{\mu_t}{\alpha L}$$

EP 0 767 569 B1

where $\mu_t$ denotes the variable adaptation stepsize and $\alpha L$ denotes a positive constant.

3. Process of adaptive identification for estimating the response of a system (10) to an input signal ($x_t$), which comprises receiving on the one hand the input signal and on the other hand an observation signal ($y_t$), a component of which is said response to the input signal, determining an error signal ($e_t$) by subtracting from the observation signal the input signal filtered by an identification filter (18) with finite impulse response representative of the response of said system, and adapting the coefficients of the identification filter by taking into account the input signal, the error signal and a forgetting factor, **characterized in that** the value of the forgetting factor $\lambda_t$ is varied according to:

$$\lambda_t = 1 - \left( \frac{a}{c + d.P2_t/P1_t} \right)/\alpha L$$

where a, c, d and $\alpha L$ denote positive constants, $P1_t$ denotes an estimate at the relevant instant of the power of the input signal and $P2_t$ denotes an estimate at the relevant instant of the power of the observation signal or of a disturbance component of said observation signal.

4. Device for adaptive identification of a system (10) to which an input signal ($x_t$) is applied, comprising:

- a first input (E1) receiving the input signal ;
- a second input (E2) receiving an observation signal ($y_t$), a component of which is a response of said system to the input signal ;
- an identification filter (18) with finite impulse response representative of the response of said system ;
- a subtractor (20) producing an error signal ($e_t$) by subtracting from the observation signal the input signal filtered by the identification filter ; and
- means (22) for adapting the coefficients of the identification filter as a function of the input signal, the error signal and an adaptation stepsize,

    **characterized in that** it further comprises:

- first means (24) for estimating the power ($P1_t$) of the input signal ;
- second means (26) for estimating the power ($P2_t$) of the observation signal or of a disturbance component of said observation signal ; and
- means (28) for calculating the adaptation stepsize delivered to the adaptation means (22), the adaptation stepsize $\mu_t$ varying according to the formula:

$$\mu_t = \frac{a}{c + d.P2_t/P1_t}$$

where a, c and d denote positive constants, $P1_t$ is the power estimate provided by the first estimation means (24) and $P2_t$ is the power estimate provided by the second estimation means (26).

5. Device according to Claim 4, **characterized in that** the means (22) for adapting the coefficients of the identification filter take into account a variable forgetting factor $\lambda_t$ calculated by the calculation means (28) according to:

$$\lambda_t = 1 - \frac{\mu_t}{\alpha L}$$

where $\mu_t$ denotes the variable adaptation stepsize and $\alpha L$ denotes a positive constant.

6. Device for adaptive identification of a system (10) to which an input signal ($x_t$) is applied, comprising:

- a first input (E1) receiving the input signal ;
- a second input (E2) receiving an observation signal ($y_t$), a component of which is a response of said system

13

to the input signal ;
- an identification filter (18) with finite impulse response representative of the response of said system ;
- a subtractor (20) producing an error signal ($e_t$) by subtracting from the observation signal the input signal filtered by the identification filter ; and
- means (22) for adapting the coefficients of the identification filter as a function of the input signal, the error signal and a forgetting factor,

**characterized in that** it further comprises:

- first means (24) for estimating the power ($P1_t$) of the input signal ;
- second means (26) for estimating the power ($P2_t$) of the observation signal or of a disturbance component of said observation signal ; and
- means (28) for calculating the forgetting factor delivered to the adaptation means (22), the forgetting factor $\lambda_t$ varying according to the formula:

$$\lambda_t = 1 - \left( \frac{a}{c + d.P2_t / P1_t} \right)^{1/\alpha L}$$

where a, c, d and $\alpha L$ denote positive constants, $P1_t$ is the power estimate delivered by the first estimation means (24) and $P2_t$ is the power estimate delivered by the second estimation means (26).

7. Adaptive echo canceller for removing, from a return signal ($y_t$), echo components of a forward signal ($x_t$), **charac-terized in that** it comprises an identification device (16) in accordance with any one of Claims 4 to 6, whose first input (E1) receives the forward signal ($x_t$) as input signal and whose second input (E2) receives the return signal ($y_t$) as observation signal, the error signal ($e_t$) constituting the output signal from the echo canceller.

FIG.1.

EP 0 767 569 B1

FIG.2.

FIG. 3.

# FIG.4.

$$P1_t = \lambda_1.P1_{t-1} + (1-\lambda_1)x'^2_t$$
$$P2_t = \lambda_1.P2_{t-1} + (1-\lambda_2)y^2_t$$

50

oui — $P1_t > T?$ — non

51

53 — $\mu_t = \dfrac{a}{c+d.P2_t/P1_t}$

$\mu_t = 0$ — 52

$f = 1-\alpha.\mu_t$ — 54

oui — $\mu_t < T1?$ — non

55

56 — $f = 1$

oui — $\mu_t > T2?$ — non

57

$f = \beta.f$ — 58

$$Ge_t = \gamma.Ge_{t-1} + (1-\gamma).f$$
$$Gr_t = 1-\delta.Ge_t$$

59